# EUROPEAN PATENT APPLICATION

(11) **EP 0 552 763 A2**
(43) Date of publication of application: **28.07.1993**
(21) Application number: 93100888.2
(22) Date of filing: 21.01.1993
(51) Int. Cl.: H01L 29/812, H01L 29/40, H01L 29/54, H01L 21/28

(54) **Compound semiconductor device with self-aligned gate and method of producing this compound semiconductor device**

(30) Priority: 22.01.1992 JP 32740/92
(71) Applicant: MITSUBISHI DENKI KABUSHIKI KAISHA, Chiyoda-ku Tokyo-to, 100 (JP)
(72) Inventor: Sakai, Masayuki, c/o Mitsubishi Denki K.K., 4-chome, Itami-shi, Hyogo-ken 664 (JP)
(74) Representative: KUHNEN, WACKER & PARTNER

(57) **Abstract**

In a method of producing a compound semiconductor device, a semiconductor layer which makes no alloy with a metal electrode that is to be disposed thereon but makes an ohmic contact with the metal electrode is formed as an uppermost layer in a lamination of epitaxial layers, an ohmic electrode which is easily removed by chemical etching is deposited thereon, a first insulating film is deposited thereon, a groove is formed by chemical etching at a region where a gate is to be formed to expose an active layer, a second insulating film is deposited thereon and etched to form insulating side walls on the internal surface of the groove, and a gate electrode whose shape is regulated by the first insulating film and the side walls is formed. Therefore, the gate electrode and the source electrode are formed self-alignedly with each other, and the interval between the gate electrode and the ohmic electrode is reduced to the width of the side wall, whereby the source resistance is reduced. In addition, since the operation layer, i.e., the uppermost semiconductor layer is not damaged during the formation of the groove, a compound semiconductor device with high performance and high reliability is achieved.

## Description

### FIELD OF THE INVENTION

The present invention relates to a field effect semiconductor device formed on a compound semiconductor substrate and a production method thereof.

### BACKGROUND OF THE INVENTION

In order to improve characteristics of a field effect semiconductor device, it is important to reduce a source resistance, and a gate resistance which is a parasitic resistance. The reduction of the source resistance is achieved by reducing an interval between a gate electrode and a source electrode.

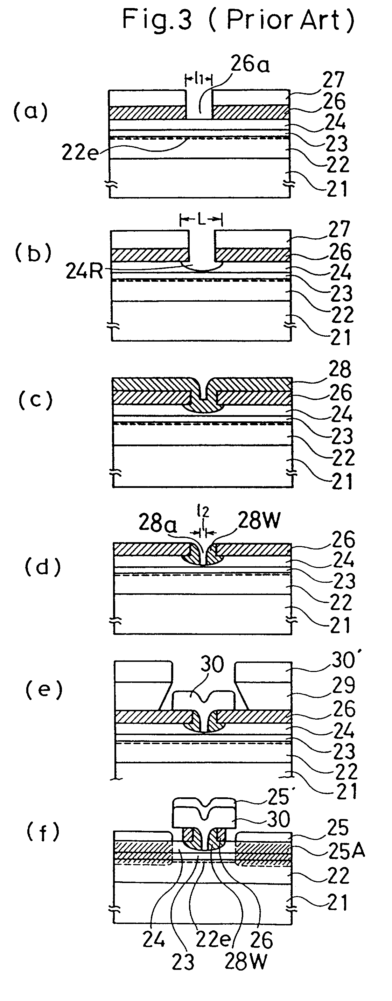

Figures 3(a)-3(f) are cross-sectional views illustrating process steps in a method of producing a prior art field effect semiconductor device, disclosed in Japanese Published Patent Application No. 63-174374. In the figures, reference numeral 21 designates a semi-insulating GaAs substrate. An undoped GaAs layer 22, an n type AlGaAs layer 23, and an n type GaAs layer 24 are successively disposed on the substrate 21. Reference numeral 26 designates a first insulating film through which an aperture 26a is formed using a photoresist mask 27. A recess structure 24R is formed in the n type GaAs layer 24 through the aperture 26a. Reference numeral 28 designates a second insulating film which is etched back to form side walls 28W. Reference numeral 29 designates a photoresist mask used for deposition and lift-off of a lower gate electrode 30. An upper gate electrode 25' is disposed on the lower gate electrode 30 and ohmic electrodes 25 are disposed on the n type GaAs layer at opposite sides of the gate electrode. The upper gate electrode 25' and the ohmic electrodes 25 are formed at the same time.

A description is given of the production process.

Initially, there are successively grown on the semi-insulating GaAs substrate 21 an undoped GaAs layer 22 about 0.5 ∼ 1 micron thick, an n type AlGaAs layer 23 about 40 nm thick to which silicon is doped to a concentration of about 2 X 10¹⁸ cm⁻³, and an n type GaAs layer 24 about 120 nm thick to which silicon is doped to a concentration of about 2 X 10¹⁸ cm⁻³. Preferably, these layers are epitaxially grown by molecular beam epitaxy (MBE) or metal organic chemical vapor deposition (MOCVD). A two-dimensional electron gas 22e is produced in the undoped GaAs layer 22 in the vicinity of a heterojunction between the undoped GaAs layer 22 and the n type AlGaAs layer 23.

Then, silicon oxide (SiO₂) is deposited on the n type GaAs layer 24 to a thickness of about 0.3 micron to form a first insulating film 26. Then, a photoresist 27 is applied onto the first insulating film 26 and a stripe-shaped opening is formed through the photoresist 27. Then, using the photoresist 27 as a mask, the first insulating film 26 is etched by a dry etching using CHF₃, CF₄, or the like to form an opening 26a as shown in figure 3(a). The width l₁ of the opening 26a is, for example, 0.5 micron.

Then, a reactive ion etching (RIE) using CCl₂F₂ or a wet etching using an etchant comprising fluoric acid and hydrogen peroxide solution is carried out using the photoresist 27 and the first insulating film 26 as a mask, whereby a recess structure 24R is formed in the n type GaAs layer 24 (figure 3(b)). For example, the depth of the recess structure 24R is 0.1 micron and the maximum width of the side-etched portion beneath the SiO₂ film 26 is 0.1 micron. Since the width l₁ of the opening 26a is 0.5 micron, the width L of the recess structure 24R is approximately 0.7 micron.

After the photoresist 27 is removed, SiO₂ is deposited onto the whole surface of the wafer by plasma CVD or the like to form a second insulating film 28 (figure 3(c)). The recess structure 24R is completely filled with the SiO₂ film 28.

Thereafter, the second insulating film 28 is etched in a direction vertical to the plane surface of the wafer by RIE or the like to form an opening 28a, leaving side walls 28W (figure 3(d)). The width l₂ of the opening 28a is about 0.25 micron.

Then, a photoresist 29 with an opening having a width of about 1 micron and a trapezoid section is formed on the first insulating film 26. Using the photoresist 29 as a mask, a metal layer, such as Ti/Pt/Au, is deposited to a thickness of about 0.5 micron to form a lower gate electrode 30 (figure 3(e)). At this time, the gate metal layer 30' is deposited on the photoresist 29.

Thereafter, the photoresist 29 is removed by acetone together with the gate metal layer 30' by lift-off, and the first insulating film 26 is removed by RIE using the lower gate electrode 30 as a mask. Then, a metal layer, such as AuGe/Ni/Au, is deposited on the wafer as an ohmic-contact electrode layer and an annealing is carried out to form source and drain electrodes 25 beneath which alloyed regions 25A reach into the two-dimensional electron gas 22e. The AuGe/Ni/Au layer deposited on the lower gate electrode 30 serves as an upper gate electrode 25'.

In this prior art method, since the source and drain electrodes are deposited using the gate electrode as a mask, the source and drain electrodes are aligned with the gate electrode and, therefore, the source electrode is close to the gate electrode, whereby the source parasitic resistance is reduced. In addition, since the ohmic electrode metal is also deposited on the gate electrode 30, the gate parasitic resistance is reduced.

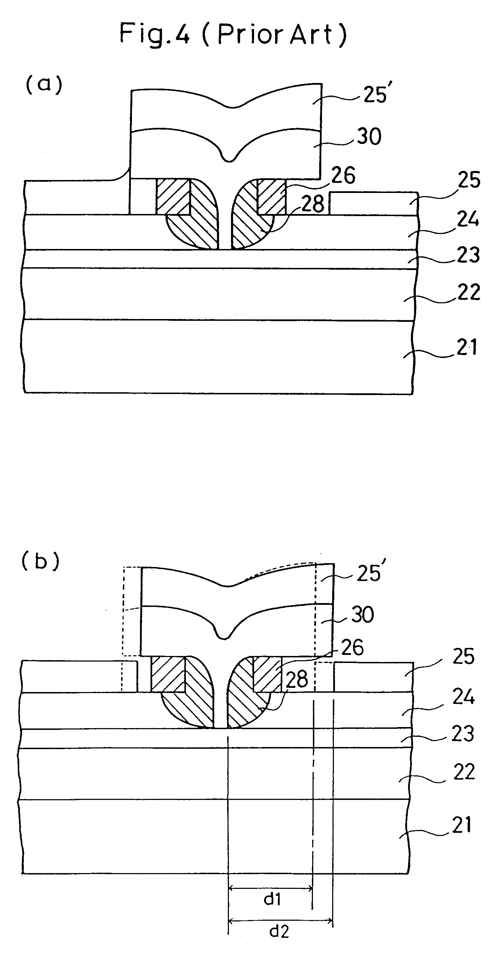

However, since the ohmic electrodes, i.e., source and drain electrodes, are deposited using the gate electrode as a mask, if the thickness of the ohmic electrodes is increased to further reduce the gate parasitic resistance, the ohmic electrodes are unfavorably short-circuited with the gate electrode as shown in figure 4(a). In addition, the interval between the gate electrode and the ohmic electrode is determined by the dimension of the upper portion of the gate electrode, so that the minimum value thereof is determined by precision in the photolithography and precision in the process of forming the gate electrode and it is impossible to make the interval narrower than the minimum value. Furthermore, an interval between the gate and source electrodes unfavorably changes as shown in figure 4(b) because of a misregistration of the photoresist pattern 29 which is used as a mask during the formation of the gate electrode, whereby the source resistance varies.

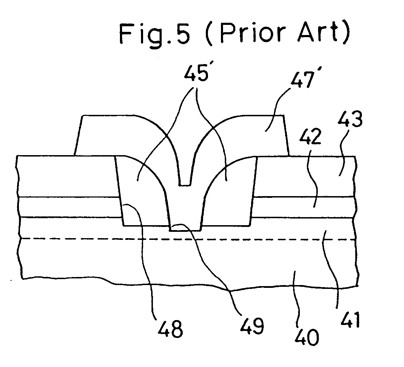

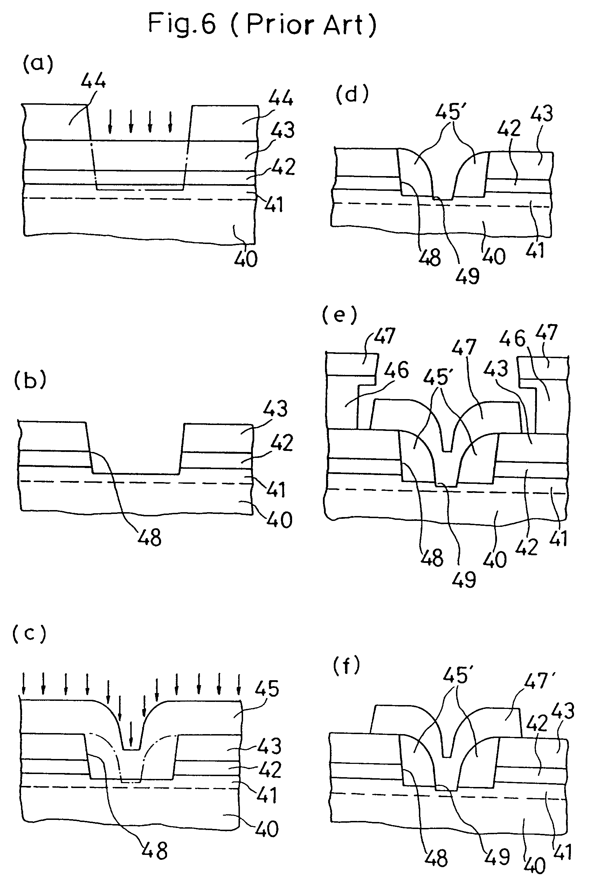

Figure 5 illustrates another prior art MESFET disclosed in Japanese Published Patent Application No. 1-133375 and figures 6(a)-6(f) are cross-sectional views illustrating process steps for producing the MESFET. In figure 5, a doped region 41 is formed in the surface region of the semi-insulating GaAs substrate 40. A first metal layer 42 is disposed on the doped region 41 and makes an ohmic contact with the doped region 41. An insulating film 43 is disposed on the metal layer 42. A groove 48 penetrates through the insulating film 43 and the metal layer 42 and reaches into the doped region 41. Insulating side walls 45' are disposed on the internal side surface of the groove 48. A gate electrode 47' is disposed on the bottom surface of a groove 49 which is formed between the side walls 45', on the side walls 45', and on portions of the insulating films 43.

Initially, ions are selectively implanted into the surface region of the semi-insulating GaAs substrate 40 to form the doped region 41. At this time, lattice defects occur in the substrate due to the selective ion implantation, so that an annealing is carried out as a recovery treatment. Then, a metal layer 42 is evaporated and deposited on the whole surface of the doped region 41 by CVD or the like. The metal layer 42 is alloyed with the semiconductor material of the substrate and produces an ohmic contact with the semiconductor substrate. Then, an SiO₂ layer 43 is formed on the whole surface of the metal layer 42.

Then, a photoresist 44 is applied onto the wafer and patterned to form an aperture at a position where a gate electrode will be formed. Using the photoresist pattern 44 as a mask, anisotropic etching is carried out as shown by arrows in figure 6(a). This anisotropic etching is carried on until the etching front reaches a position shown by the dashed line of figure 6(a), i.e., the doped region 41, resulting in a groove 48 shown in figure 6(b). After the anisotropic etching, the photoresist 44 is removed and an insulating layer 45 is formed on the whole surface of the wafer. Then, a portion of the insulating layer 45 is anisotropically etched in a direction vertical to the plane surface of the wafer as shown in figure 6(c). During the anisotropic etching, the insulating layer 45 is etched back to a position shown by the dashed line in figure 6(c), whereby side walls 45' are formed in the groove 48 and an aperture 49 is formed between the side walls 45' (figure 6(d)). Then, a photoresist 46 having an aperture at a position where a gate electrode will be formed is formed on the insulating film 43. Using the photoresist pattern 46 as a mask, a gate metal 47 is deposited as shown in figure 6(e). Then, the gate metal 47 deposited on the photoresist 46 is removed together with the photoresist 46 by lift-off, resulting in a gate electrode 47' shown in figure 6(f).

According to this prior art method, the gate electrode and the source electrode are formed self-alignedly with each other, and the interval between the gate electrode and the ohmic electrode can be reduced to the thickness of the insulating side wall, so that the minimum value thereof is not determined by the precision in the photolithography and the precision in the process of forming the gate electrode, whereby the source resistance is reduced. In addition, since the misregistration of the mask pattern in the formation of the gate electrode does not affect on the gate-to-source distance, variation in the source resistance is avoided. In addition, since the thickness of the source and drain electrodes is set independent of the thickness of the gate electrode, the gate resistance is easily reduced.

In the prior art device shown in figure 5, however, an alloy including gold which is not easily patterned by chemical etching is used as the metal layer 42 which is alloyed with the doped region 41 and makes an ohmic contact with the doped region 41. Therefore, in the etching step of figure 6(a), physical etching, such as sputter etching or ion milling, should be employed. In this case, the doped region 41 beneath the metal layer 42 is damaged during the etching, deteriorating characteristics and reliability of the device.

### SUMMARY OF THE INVENTION

An object of the present invention is to provide a compound semiconductor device with high performance and high reliability, in which the thickness of the gate electrode is controlled independent of the thickness of the ohmic electrode and the ohmic electrode is formed self-alignedly with the gate electrode.

Other objects and advantages of the present invention will become apparent from the detailed description given hereinafter; it should be understood, however, that the detailed description and specific embodiment are given by way of illustration only, since various changes and modifications within the spirit and the scope of the invention will become apparent to those skilled in the art from this detailed description.

According to an aspect of the present invention, a compound semiconductor device comprises a semi-insulating compound semiconductor substrate; compound semiconductor layers epitaxially grown on the substrate, including a semiconductor layer as an uppermost layer which makes no alloy with a metal electrode disposed thereon but makes an ohmic contact with the metal electrode; an ohmic electrode disposed on the uppermost semiconductor layer, which comprises a material easily etched by chemical etching; a first insulating film disposed on the ohmic electrode; a groove formed by chemical etching, penetrating through at least the first insulating film, the ohmic electrode, and the uppermost semiconductor layer; side walls comprising a second insulating film disposed on the internal surface of the groove; and a gate electrode disposed on the bottom of the groove, the side walls, and the first insulating film, which gate electrode produces a Schottky junction with the semiconductor layer exposed at the bottom of the groove. In this structure, the uppermost semiconductor layer serving as an operation layer is not damaged when the ohmic electrode disposed thereon is etched to form the groove, resulting in a compound semiconductor device with high performance and high reliability.

According to another aspect of the present invention, a method of producing a compound semiconductor device comprising epitaxially growing semiconductor layers on a compound semiconductor substrate, which semiconductor layers include a semiconductor layer as an uppermost layer that makes no alloy with a metal electrode disposed thereon but makes an ohmic contact with the metal electrode; depositing a metal, which is easily removed by chemical etching, on the uppermost semiconductor layer to form an ohmic electrode; depositing a first insulating film on the ohmic electrode; forming a groove penetrating at least the first insulating film, the ohmic electrode, and the uppermost semiconductor layer; depositing a second insulating film on the whole surface of the wafer and etching the second insulating film to form insulating side walls on the internal surface of the groove; and forming a gate electrode which produces a Schottky junction with the semiconductor layer exposed at the bottom of the groove and whose shape is regulated by the first insulating film and the side walls. In this method, since the ohmic electrode is etched by chemical etching when the groove is formed, the semiconductor layer beneath the ohmic electrode is not damaged. In addition, the gate electrode and the ohmic electrode are formed self-alignedly and close to each other with the side wall between them. Furthermore, the thickness of the gate electrode is set independent of the thickness of the ohmic electrode.

### BRIEF DESCRIPTION OF THE DRAWINGS

Figure 1 is a cross-sectional view illustrating a compound semiconductor device in accordance with an embodiment of the present invention;
Figures 2(a)-2(f) are cross-sectional views illustrating process steps in a method of producing the compound semiconductor device of figure 1;
Figures 3(a)-3(f) are cross-sectional views illustrating process steps in a method of producing a compound semiconductor device in accordance with the prior art;
Figures 4(a) and 4(b) are cross-sectional views for explaining problems in the method of producing a compound semiconductor device in accordance with the prior art;
Figure 5 is a cross-sectional view illustrating a compound semiconductor device in accordance with the prior art; and
Figures 6(a)-6(f) are cross-sectional views in process steps in a method of producing the compound semiconductor device of figure 5.

### DETAILED DESCRIPTION OF THE PREFERRED EMBODIMENTS

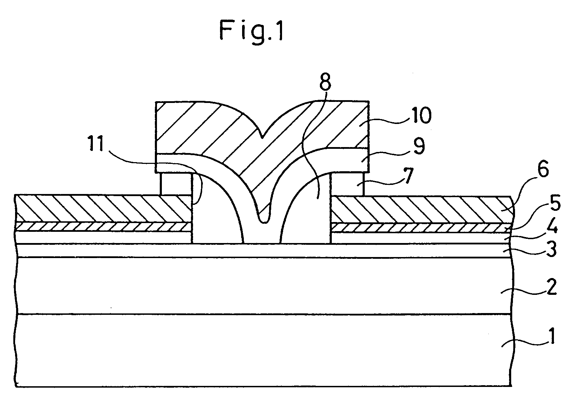

Figure 1 is a cross-sectional view illustrating a compound semiconductor device in accordance with an embodiment of the present invention. In figure 1, an undoped GaAs epitaxial layer 2 is disposed on a semi-insulating GaAs substrate 1. An n type AlGaAs epitaxial layer 3 is disposed on the undoped GaAs epitaxial layer 2. An n⁺ type GaAs epitaxial layer 4 is disposed on the n type AlGaAs epitaxial layer 3. An n⁺ type InGaAs epitaxial layer 5 is disposed on the n⁺ type GaAs epitaxial layer 4. A non-alloyed ohmic electrode 6 is disposed on the n⁺ type InGaAs epitaxial layer 5. An insulating film 7 is disposed on the non-alloyed ohmic electrode 6. A groove 11 penetrates through the insulating film 7, the non-alloy ohmic electrode 6, the n⁺ type InGaAs epitaxial layer 5, and the n⁺ type GaAs epitaxial layer 4. Insulating side walls 8 are disposed on the internal side surface of the groove 11. A lower gate electrode 9 is disposed on the n type AlGaAs epitaxial layer 3 exposed at the bottom of the groove 11, the side walls 8, and the insulating film 7. An upper gate electrode 10 is disposed on the lower gate electrode 9.

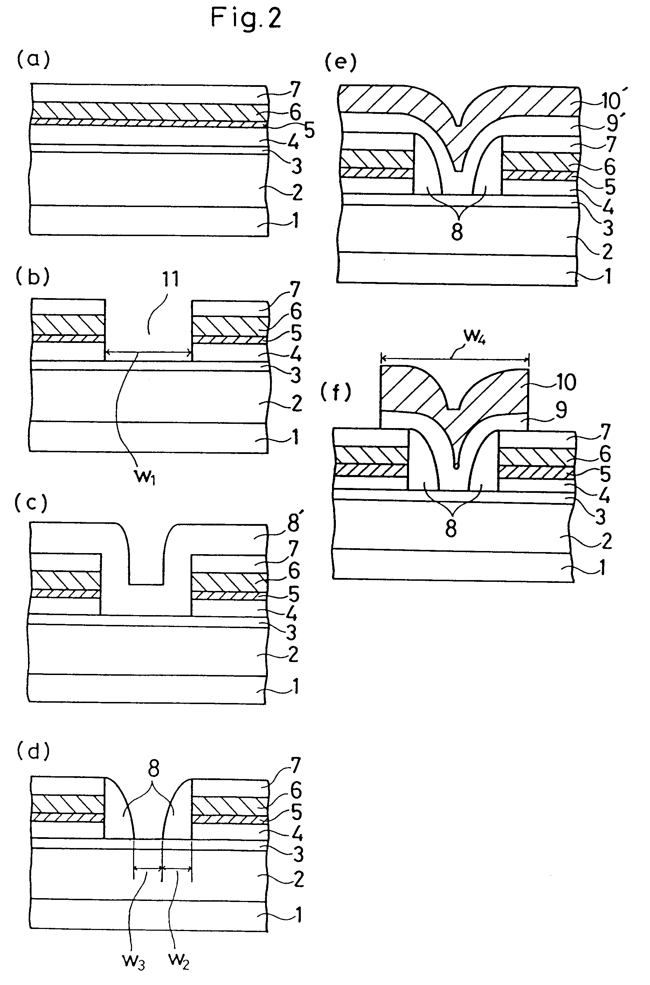

Figures 2(a)-2(f) illustrate process steps in producing the compound semiconductor device of figure 1.

Initially, there are successively grown on the semi-insulating GaAs substrate 1, an undoped GaAs layer 2 several microns thick, an n type AlGaAs layer 3 400 ∼ 500 angstroms thick, an n⁺ type GaAs layer 4 about 1500 angstroms thick, and an n⁺ type InGaAs layer 5 100 ∼ 150 angstroms thick. Preferably, these layers are epitaxially grown by MBE. Thereafter, aluminum is deposited on the n⁺ type InGaAs epitaxial layer 5 to a thickness of about 0.2 micron by plasma CVD to form a non-alloyed ohmic electrode 6. Then, an insulating film 7 is deposited on the non-alloyed ohmic electrode 6 to a thickness of more than 0.2 micron by plasma CVD, completing the structure of figure 2(a).

Then, a photoresist mask having an aperture at a region where a gate electrode will be formed is formed on the insulating film 7. Using the mask as an etching mask, the insulating film 7 is etched by reactive ion etching (RIE) using a gas comprising CHF₃ and O₂, and the non-alloyed ohmic electrode 6 and the n⁺ type InGaAs epitaxial layer 5 are etched by RIE using Cl gas, and then the n⁺ type GaAs epitaxial layer 4 is etched by RIE using CCl₂F₂ gas, resulting in a groove 11 having a width W1 of about 0.6 micron (figure 2(b)).

In the step of figure 2(b), the n⁺ type InGaAs layer 5, which makes no alloy with a metal layer disposed thereon but makes an ohmic contact with the metal layer, is present at the top of the lamination of the semiconductor layers, and aluminum is used for the non-alloyed ohmic electrode. Therefore, the non-alloyed ohmic electrode is easily etched by etching utilizing chemical reaction, such as RIE, not by etching utilizing pure physical reaction, such as sputter etching or ion milling. Accordingly, the semiconductor layer beneath the non-alloyed ohmic electrode is not damaged by the physical etching, resulting in a semiconductor device with high performance and high reliability.

Then, as illustrated in figure 2(c), a second insulating film 8' is deposited on the insulating film 7 and the n type AlGaAs epitaxial layer 3 exposed at the bottom of the groove 11 to a thickness of about 0.2 micron by plasma CVD.

Then, the second insulating film 8' is etched back by RIE to form side walls 8 on the internal surface of the groove 11 as shown in figure 2(d). Since the width of the side wall 8 w₂ is about 0.2 micron, an interval w₃ between the opposite side walls, which decides a gate length, is about 0.2 micron (= w₁ - 2w₂).

Then, as illustrated in figure 2(e), a refractory metal 9', such as tungsten silicide, is deposited on the whole surface of the wafer to a thickness of about 300 angstroms by sputtering. Then, a metal 10', such as gold, is deposited on the refractory metal layer 9' to a thickness of about 5000 angstroms by sputtering.

Then, as illustrated in figure 2(f), the metal layer 10' and the refractory metal layer 9' are etched by ion milling and RIE, respectively, so that the width w₄ may be about 1 micron, resulting a gate electrode comprising a lower gate electrode 9 and an upper gate electrode 10. Thereafter, the insulating film 7 is partially etched away using the gate electrode as a mask to complete the compound semiconductor device shown in figure 1.

In this way, a field effect semiconductor device, in which the interval between the gate electrode and the ohmic electrode is reduced to the width of the insulating side wall, is achieved.

According to the above-described embodiment of the present invention, the gate electrode and the source electrode are formed self-alignedly and the interval between the gate electrode and the ohmic electrode is reduced to the width of the insulating side wall, so that the minimum value of the interval is not restricted by the precision in photolithography and the precision in the process of forming the gate electrode, whereby the source resistance is reduced. In addition, since the interval between the gate electrode and the source electrode is determined by the width of the side walls, misregistration of the mask pattern used in producing the gate electrode does not affect on the gate-to-source interval, so that variation in the source resistance due to the misregistration of the pattern is avoided. Furthermore, the thickness of the source and drain electrodes is set independent of the thickness of the gate electrode, the gate resistance is easily reduced. In addition, since the gate electrode has a two-layer structure comprising the lower gate electrode 9 and the upper gate electrode 10, a low gate resistance and desired Schottky characteristics are achieved.

In addition, since the n⁺ InGaAs layer, which makes no alloy with the metal layer disposed thereon but makes an ohmic contact with the metal layer, is used as the uppermost layer of the epitaxial layers, aluminum or the like which is easily removed by chemical etching is used as the ohmic electrode. Therefore, when the groove 11 is formed, the semiconductor layer, serving as an operation layer, beneath the ohmic electrode is not damaged by the etching, resulting in a compound semiconductor device with high performance and high reliability.

In the compound semiconductor device shown in figure 1, it is supposed that a capacitance should be produced in a region where the gate electrode and the ohmic electrode overlap each other through the insulating film 7 and this capacitance should cause deterioration in device characteristics. However, this is avoided by increasing the thickness of the insulating film 7. For example, when the thickness of the insulating film 7 is more than 0.2 micron as described in the embodiment of the present invention, deterioration in characteristics caused by the capacitance is negligible.

In the above-described embodiment, the epitaxially grown layers include the undoped GaAs layer 2 and the n type AlGaAs layer 3 disposed thereon and the two-dimensional electron gas produced in the vicinity of the boundary between the layers 2 and 3 is utilized to constitute a high electron mobility transistor (HEMT). However, other combinations of epitaxially grown layers are possible so long as a semiconductor layer, which makes an ohmic contact with a metal layer disposed thereon without being alloyed with the metal layer, is present at the top of the epitaxially grown layers.

In the above-described embodiment, the gate electrode is formed by depositing a metal on the whole surface of the wafer by sputtering and then removing portions thereof by etching. However, the gate electrode may be formed by deposition and lift-off as illustrated in figure 6(e). In addition, although the gate electrode comprises the two-layer structure, it may comprise a single metal layer.

As is evident from the foregoing description, according to the present invention, a compound semiconductor device comprises a semi-insulating compound semiconductor substrate; compound semiconductor layers epitaxially grown on the substrate, including a semiconductor layer as an uppermost layer which makes no alloy with a metal electrode disposed thereon but makes an ohmic contact with the metal electrode; an ohmic electrode disposed on the uppermost semiconductor layer, which comprises a material easily etched by chemical etching; a first insulating film disposed on the ohmic electrode; a groove formed by chemical etching, penetrating through at least the first insulating film, the ohmic electrode, and the uppermost semiconductor layer; side walls comprising a second insulating film disposed on the internal surface of the groove; and a gate electrode disposed on the bottom of the groove, the side walls, and the first insulating film, which gate electrode produces a Schottky junction with the semiconductor layer exposed at the bottom of the groove. Since this device includes an operation layer which is not damaged during the production process, a compound semiconductor device with high performance and high reliability is achieved.

In addition, according to the present invention, a lamination structure of semiconductor layers, which includes a semiconductor layer as an uppermost layer that makes no alloy with a metal electrode disposed thereon but makes an ohmic contact with the metal electrode, is epitaxially grown on the entire surface of a compound semiconductor substrate; a metal, which is easily removed by chemical etching, is deposited on the uppermost semiconductor layer to form an ohmic electrode; a first insulating film is deposited on the ohmic electrode; a groove is formed penetrating at least the first insulating film, the ohmic electrode, and the uppermost semiconductor layer; a second insulating film is deposited on the whole surface of the wafer and etched to form insulating side walls on the internal surface of the groove; and a gate electrode is formed. The gate electrode produces a Schottky junction with the semiconductor layer exposed at the bottom of the groove and the shape of the gate electrode is regulated by the first insulating film and the side walls. Therefore, the gate electrode and the source electrode are formed self-alignedly with each other, and the interval between the gate electrode and the ohmic electrode is reduced to the width of the side wall, so that the minimum value of the interval is not restricted by the precision in the photolithography and the precision in the formation of the gate electrode, whereby the source resistance is reduced. In addition, variation in the source resistance caused by misregistration of the mask pattern is avoided. In addition, since the thickness of the gate electrode is set independent of the thickness of the ohmic electrode, the gate resistance is easily reduced. Furthermore, since the operation layer is not damaged during the production process, a compound semiconductor device with high performance and high reliability is achieved.

## Claims

1. A compound semiconductor device comprising:
a semi-insulating compound semiconductor substrate;
compound semiconductor layers epitaxially grown on said substrate, including a semiconductor layer as an uppermost layer which makes no alloy with a metal electrode disposed thereon but makes an ohmic contact with said metal electrode;
an ohmic electrode disposed on said uppermost semiconductor layer, which comprises a material easily etched by chemical etching;
a first insulating film disposed on said ohmic electrode;
a groove formed by chemical etching, penetrating through at least said first insulating film, said ohmic electrode, and said uppermost semiconductor layer;
side walls comprising a second insulating film disposed on the internal surface of said groove; and
a gate electrode disposed on the bottom of said groove, said side walls, and said first insulating film, which gate electrode produces a Schottky junction with the semiconductor layer exposed at the bottom of said groove.

2. The compound semiconductor device of claim 1 wherein said uppermost semiconductor layer comprises InGaAs.

3. The compound semiconductor device of claim 2 wherein said semi-insulating compound semiconductor substrate comprises GaAs and said epitaxially grown layers are an undoped GaAs layer, an n type AlGaAs layer, an n⁺ type GaAs layer, and an n⁺ type InGaAs layer.

4. The compound semiconductor device of claim 1 wherein said ohmic electrode comprises aluminum.

5. The compound semiconductor device of claim 1 wherein said gate electrode includes an upper gate electrode comprising a low resistance metal disposed on said gate electrode.

6. The compound semiconductor device of claim 5 wherein said gate electrode comprises tungsten silicide and said upper gate electrode comprises gold.

7. The compound semiconductor device of claim 1 wherein the thickness of said first insulating film is more than 0.2 micron.

8. A method of producing a compound semiconductor device comprising:
epitaxially growing semiconductor layers on a compound semiconductor substrate, which semiconductor layers include a semiconductor layer as an uppermost layer that makes no alloy with a metal electrode disposed thereon but makes an ohmic contact with the metal electrode;
depositing a metal, which is easily removed by chemical etching, on said uppermost semiconductor layer to form an ohmic electrode;
depositing a first insulating film on said ohmic electrode;
forming a groove penetrating at least said first insulating film, said ohmic electrode, and said uppermost semiconductor layer;
depositing a second insulating film on the whole surface of the wafer and etching said second insulating film to form insulating side walls on the internal surface of said groove; and
forming a gate electrode which produces a Schottky junction with the semiconductor layer exposed at the bottom of said groove and whose shape is regulated by said first insulating film and said side walls.

9. The method of claim 8 wherein said groove penetrating through said uppermost semiconductor layer is formed by reactive ion etching.

10. The method of claim 8 wherein the formation of said gate electrode comprises depositing a refractory metal on the bottom of said groove, said side walls, and said first insulating film by sputtering and patterning said refractory metal in a desired shape using reactive ion etching.

11. The method of claim 10 wherein a low resistance metal layer is deposited on said refractory metal by sputtering, said low resistance metal layer is formed in a desired shape by ion milling, and said refractory metal layer is formed in a desired shape by reactive ion etching.

12. The method of claim 11 wherein tungsten silicide is used as said refractory metal and gold is used as said low resistance metal.
